# EUROPEAN PATENT APPLICATION

(11) **EP 3 690 960 A1**
(43) Date of publication of application: **05.08.2020**
(21) Application number: 18862356.5
(22) Date of filing: 27.09.2018
(51) Int. Cl.: H01L 31/055

(54) **SOLAR CELL SYSTEM**

(30) Priority: 29.09.2017 JP 2017192257
(71) Applicant: Sekisui Chemical Co., Ltd., Osaka-shi, Osaka 530-8565 (JP)
(72) Inventor: OOTA, Yuusuke, Koka-shi, Shiga 528-8585 (JP); YOSHIDA, Shougo, Koka-shi, Shiga 528-8585 (JP); MATSUDOU, Masaki, Mishima-gun Osaka 618-0021 (JP); II, Daizou, Koka-shi, Shiga 528-8585 (JP); IZU, Yasuyuki, 6045 JB Roermond (NL); NAKAJIMA, Daisuke, Koka-shi, Shiga 528-8585 (JP); CHOU, Kinryou, Koka-shi, Shiga 528-8585 (JP)
(74) Representative: Ter Meer Steinmeister & Partner
(86) International application number: PCT/JP2018/036137
(87) International publication number: WO 2019/065920

(57) **Abstract**

A solar cell system for generating electricity by absorbing sunlight, comprising a laminated structure and a power generation cell disposed in a peripheral area of the laminated structure, wherein, in the laminated structure, a transparent sheet member comprising a wavelength conversion material and a first transparent sheet are laminated, a maximum emission wavelength of the wavelength conversion material is 780 nm or more, and a refractive index nₐ₁ of the first transparent sheet is higher than a refractive index n_{b} of the transparent sheet member. According to the present invention, can provide a solar cell system including a power generation cell and a transparent layer capable of efficiently guiding light to a side surface, wherein, inside the transparent layer, light having been incident on a surface of the transparent layer is converted into light with a long wavelength, such as near infrared radiation.

## Description

### Technical Field

The present invention relates to a solar cell system used for solar power generation or other applications on a window.

### Background Art

Since it is difficult to secure enough space for installing solar panels in a comparatively high construction such as a building, energy creation is not sufficient. Hence, such an approach that solar cells are mounted on windows has been put to practical uses. Specifically, a system in which a solar cell module is disposed in an intermediate layer of laminated glass, as an intermediate layer, and a system in which a solar cell module is disposed between plates of glass of double glazing are known. However, the transparency of a solar cell module is generally low, and the solar cell module often impairs visibility. Highly transparent organic solar cells are also in practical use, but have the problem that they don't have sufficient durability.

To address the above problems, disposing a solar panel in a peripheral area, such as a window frame, of a window has been studied. For example, a solar radiation conversion device has been developed that contains, in a transparent member such as glass, a wavelength conversion material for converting ultraviolet radiation, visible radiation, or infrared radiation into near infrared radiation and generates electricity by gathering the light that has been converted by the wavelength conversion material onto a side surface of glass (for example, see PTL 1).

### Citation List

### Patent Literature

PTL1: WO 2015/047084 A1

### Summary of Invention

### Technical Problem

However, in the solar radiation conversion device disclosed in PTL 1, among light converted into near infrared radiation, large portion thereof is transmitted away, rather than being gathered onto the side surface of glass, so that the power generation efficiency is not sufficient. In the case where the solar radiation conversion device of PTL 1 is applied to a window of a construction, light converted into near infrared radiation may enter the room and increase the indoor temperature.

The present invention has been made in view of the above circumstances, and an object of the present invention is to provide a solar cell system including a power generation cell and a laminated structure capable of efficiently guiding light having been incident on a surface and converted inside the laminated structure into light with a long wavelength, such as near infrared radiation, to a side surface.

### Solution to Problem

The present inventors has carried out earnest investigation to find that the above problems can be solved by, in a solar cell system including a laminated structure and a power generation cell disposed in a peripheral area of the laminated structure, adjusting the refractive index of each layer constituting the laminated structure and using a specific type of wavelength conversion material, so that the present invention described below has been completed.

That is, the present invention provides [1] to [7] below.
[1] A solar cell system for generating electricity by absorbing sunlight, comprising a laminated structure and a power generation cell disposed in a peripheral area of the laminated structure, wherein, in the laminated structure, a transparent sheet member comprising a wavelength conversion material and the first transparent sheet are laminated, a maximum emission wavelength of the wavelength conversion material is 780 nm or more, and a refractive index nₐ1 of the first transparent sheet is higher than a refractive index n_{b} of the transparent sheet member.
[2] The solar cell system according to [1] above, wherein the refractive index n_{b} of the transparent sheet member is 1.30 to 1.80.
[3] The solar cell system according to [1] or [2] above, wherein the first transparent sheet is disposed on an exterior side of the transparent sheet member.
[4] The solar cell system according to any of [1] to [3] above, wherein the laminated structure comprises the transparent sheet member and first and second transparent sheets disposed on both surfaces, respectively, of the transparent sheet member.
[5] The solar cell system according to [4] above, wherein a refractive index nₐ2 of the second transparent sheet is higher than the refractive index n_{b} of the transparent sheet member.
[6] The solar cell system according to any of [1] to [5] above, wherein the transparent sheet member comprises a resin, and the wavelength conversion material is dispersed in the resin.
[7] The solar cell system according to any of [1] to [6] above, wherein the first transparent sheet is either inorganic glass or organic glass.

### Advantageous Effects of Invention

The present invention can provide a solar cell system that shows high power generation efficiency because the amount of light that is gathered onto a side surface of a laminated structure is large.

### Brief Description of Drawings

[Fig. 1] Fig. 1 is a schematic cross-sectional view of a laminated structure according to an embodiment of the present invention.
[Fig. 2] Fig. 2 is a schematic cross-sectional view of a solar cell system according to the embodiment of the present invention.

### Description of Embodiment

A solar cell system of the present invention is a solar cell system for generating electricity by absorbing sunlight, wherein the solar cell system comprises a laminated structure and a power generation cell disposed in a peripheral area of the laminated structure. In the laminated structure, a transparent sheet member containing a wavelength conversion material and a first transparent sheet are laminated, wherein the maximum emission wavelength of the wavelength conversion material is 780 nm or more and the refractive index nₐ1 of the first transparent sheet is higher than the refractive index n_{b} of the transparent sheet member.

The solar cell system of the present invention is such a system for generating electricity, in which at least part of light, such as sunlight, incident on one surface of the laminated structure is converted into light with a long wavelength by the wavelength conversion material, and then the light is reflected within the laminated structure, and thereby guided to a side surface of the laminated structure, so as to cause the light to enter the power generation cell. In the present specification, the one surface of the laminated structure means a surface of the laminated structure perpendicular to the direction of lamination of the laminated structure, and the other surface of the laminated structure means the surface opposite to the one surface.

It is not clear why the power generation efficiency of the solar cell system of the present invention is high, but the reason is speculated as follows. Part of light with a maximum emission wavelength of 780 nm or more that is emitted within the transparent sheet member having a relatively low refractive index enters the first transparent sheet having a relatively high refractive index. The light that has entered the first transparent sheet is apt to be reflected by the interface between the first transparent sheet, which has a high refractive index, and air, which has a low refractive index, and apt to remain in the laminated structure. Accordingly, light emitted by the wavelength conversion material is easily gathered onto the side surface of the laminated structure, leading to an increase in the amount of light received by the power generation cell and enhancement of the power generation efficiency of the solar cell system.

### [Laminated Structure]

The laminated structure is a layered body composed of two or more layers, in which the transparent sheet member containing the wavelength conversion material and the first transparent sheet are laminated. The refractive index nₐ1 of the first transparent sheet is higher than the refractive index n_{b} of the transparent sheet member. This structure increases the amount of light guided to the side surface of the laminated structure.

The difference nₐ1 - n_{b} between the refractive index nₐ₁ of the first transparent sheet and the refractive index n_{b} of the transparent sheet member is preferably 0.01 or more, more preferably 0.03 or more. The upper limit of nₐ₁ - n_{b} is not limited to a particular value, but is typically 0.5 or less, preferably 0.4 or less, more preferably 0.3 or less. With such nₐ₁ - n_{b}, the amount of light guided to the side surface of the laminated structure is likely to be large.

To increase the amount of light guided to the side surface of the laminated structure, the refractive index n_{b} of the transparent sheet member is preferably 1.30 to 1.80, more preferably 1.40 to 1.60. The refractive index nₐ₁ of the first transparent sheet is preferably 1.35 to 1.85, more preferably 1.45 to 1.65. The refractive indices can be measured by a method described below in Examples.

The visible light transmittance of the laminated structure is preferably 5% or more. When the visible light transmittance is 5% or more, the laminated structure transmits a certain amount of light. Accordingly, the laminated structure can be used as a transparent window because the laminated structure transmits part of light, such as sunlight, incident on one surface, so that the light outgoes from the other surface.

To enhance the transparency of the laminated structure, the visible light transmittance of the laminated structure is preferably 50% or more, more preferably 70% or more, further preferably 80% or more. Further, the visible light transmittance of the laminated structure is only required to be 100% or less, practically 99% or less. The visible light transmittance in the present invention means the average transmittance over the wavelength range of 380 nm or more and less than 780 nm.

In the solar cell system of the present invention, the laminated structure can be used for an exterior window of a building or a conveyance as described later. In such a case, the first transparent sheet is preferably disposed on the exterior side of the transparent sheet member. This structure facilitates prevention of deterioration of the transparent sheet member containing the wavelength conversion material.

The laminated structure may have a two-layered structure composed of the transparent sheet member and the first transparent sheet, or may have a structure including three or more layers, which is formed by further laminating another layer.

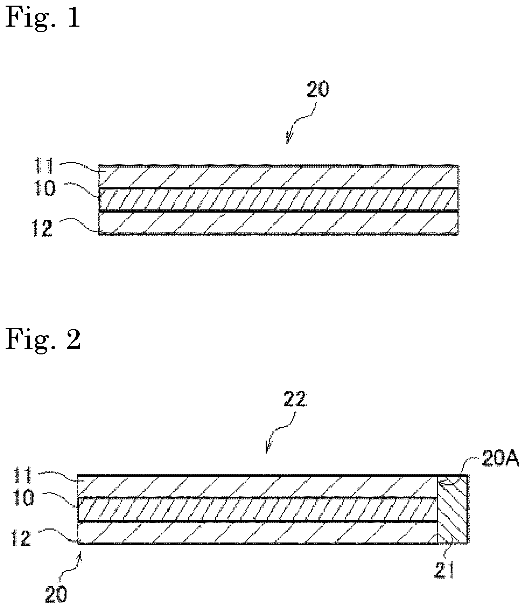

Moreover, the laminated structure preferably has a structure including three or more layers. In particular, a laminated structure 20 including a transparent sheet member 10 and a first transparent sheet 11 and a second transparent sheet 12 disposed on both surfaces, respectively, of the transparent sheet member 10 as shown in Fig. 1 is preferable. The first transparent sheet 11 is disposed as the outermost layer on the exterior side of the transparent sheet member 10, and the second transparent sheet 12 is disposed as the outermost layer on the interior side of the transparent sheet member 10.

Light such as sunlight is incident on the laminated structure 20 from the first transparent sheet 11 side. At such a case, the wavelength conversion material contained in the transparent sheet member 10 converts part of the incident sunlight into light in the near infrared region, and the light is repeatedly reflected by both surfaces of the laminated structure and is gathered onto the side surface, thereby facilitating increase in the amount of light guided to the side surface.

The refractive index nₐ₂ of the second transparent sheet is preferably higher than the refractive index n_{b} of the transparent sheet member. This structure further increases the amount of light guided to the side surface side of the laminated structure. That is, when the refractive index nₐ₁ of the first transparent sheet and the refractive index nₐ₂ of the second transparent sheet are both higher than the refractive index n_{b} of the transparent sheet member, the amount of light guided to the side surface of the laminated structure increases.

The difference nₐ₂ - n_{b} between the refractive index nₐ₂ of the second transparent sheet and the refractive index n_{b} of the transparent sheet member is preferably 0.01 or more, more preferably 0.03 or more. The upper limit of nₐ₂ - n_{b} is not limited to a particular value, but is generally 0.5 or less, preferably 0.3 or less. With such nₐ₂ - n_{b}, the amount of light guided to the side surface side of the laminated structure is likely to increase.

A preferable range of the refractive index nₐ₂ of the second transparent sheet is the same as the preferable range of the refractive index nₐ₁ of the first transparent sheet.

The structure of the laminated structure 20 in which the transparent sheet member containing the wavelength conversion material is disposed between the first and second transparent sheets effectively suppresses deterioration of the transparent sheet member.

The laminated structure is not limited to such a layered structure, but may have any other layered structure. For example, a layer other than the first transparent sheet, the transparent sheet member, and the second transparent sheet may be included. For example, in the case where the adhesion between the transparent sheet member and the first transparent sheet or the like is low, an adhesive layer may be disposed therebetween. To more efficiently guide light emitted from the wavelength conversion material to the laminated structure side and to enhance the power generation efficiency, a reflective layer such as a metal film, a heat reflecting film, and an infrared radiation reflecting film may be disposed on, for example, one surface of the second transparent sheet.

### (Transparent Sheet Member)

The transparent sheet member of the present invention contains the wavelength conversion material as described above. A material that converts light with shorter wavelengths into light with a maximum emission wavelength of 780 nm or more may be used as the wavelength conversion material. When the maximum emission wavelength of the wavelength conversion material is less than 780 nm, the amount of light guided to the side surface of the laminated structure is reduced, and the power generation efficiency of the power generation cell declines. The maximum emission wavelength of the wavelength conversion material is preferably 800 nm or more, further preferably 820 nm or more, to increase the amount of light guided to the side surface of the laminated structure and to enhance the power generation efficiency. The upper limit of the maximum emission wavelength of the wavelength conversion material is not limited to a particular value, but is preferably 1400 nm or less, more preferably 1300 nm or less, to achieve wavelength conversion and emission of light by a typical wavelength conversion material.

The maximum excitation wavelength of the wavelength conversion material is preferably 420 nm or less, more preferably 400 nm or less, further preferably 390 nm or less, particularly preferably 380 nm or less, and typically 200 nm or more, preferably 300 nm or more. With such a maximum excitation wavelength, absorption of ultraviolet radiation and conversion into near infrared radiation are easily achieved.

Specific examples of the wavelength conversion material include barium stannate (BaSnO₃), a mixed crystal containing ytterbium and cerium, a mixed crystal containing praseodymium and ytterbium, a mixed crystal containing bismuth and ytterbium, and a wavelength conversion material containing lanthanoid ions such as thulium ions. Among these materials, barium stannate is preferably used because it absorbs less light in the visible region and can achieve good transparency of a sheet-like structure. Barium stannate may be doped with ions of a metal such as iron and zinc. YSO (Y₂SiO₅) doped with ytterbium and cerium (YSO:Ce,Yb) or YSO (Y₂SiO₅) doped with praseodymium and ytterbium (YSO:Pr,Yb) may be used as the wavelength conversion material.

The wavelength conversion material may be particulate, and its average particle diameter is preferably 0.01 to 1 µm.

The transparent sheet member is not particularly limited as long as the member is transparent. Matrix materials such as various resins and inorganic glass can be used without limitation as long as the wavelength conversion material is contained in any of the matrix material. The transparent sheet member is preferably composed of a light-emitting layer comprising a resin as the matrix material in which the wavelength conversion material is dispersed.

In the case of the laminated structure in which the first and second transparent sheets are disposed on both surfaces, respectively, of the transparent sheet member in the present invention, a thermoplastic resin is preferably used as the resin. By employing a thermoplastic resin, the transparent sheet member may function as an adhesive layer with ease, so as to facilitate adhesion between the transparent sheet member and the first and second transparent sheets. Further, in such a case, good impact resistance of the laminated structure is achieved.

The content of the wavelength conversion material is preferably 0.01 to 3 parts by mass, more preferably 0.02 to 1.5 parts by mass, further preferably 0.03 to 1.0 parts by mass, relative to 100 parts by mass of the matrix material.

When the content of the wavelength conversion material is equal to or more than the lower limit, sufficient emission of light can be achieved. When the content is equal to or less than the upper limit, larger decrease in the transparency of the laminated structure than is necessary can be prevented.

A resin having a refractive index lower than the refractive index of the first transparent sheet or the refractive indices of the first and second transparent sheets is appropriately selected as the thermoplastic resin used for the transparent sheet member. Specific examples include polyvinyl acetal resins, ethylene-vinyl acetate copolymer resins, ionomer resins, polyurethane resins, and thermoplastic elastomers. By using these resins, the adhesion to the first transparent sheet and the second transparent sheet or the like is more likely to be ensured. One type of thermoplastic resin may be used singly, or two or more types of thermoplastic resins may be used in combination. Among these resins, a polyvinyl acetal resin is particularly suitable because it shows good adhesion to glass when a plasticizer is contained in the transparent sheet member.

### (Polyvinyl Acetal Resin)

The polyvinyl acetal resin used for the transparent sheet member is not particularly limited as long as the resin is a polyvinyl acetal resin obtained by acetalizing poly(vinyl alcohol) with an aldehyde, but poly(vinyl butyral) resin is suitable.

As to the degree of acetalization of the polyvinyl acetal resin, the preferred lower limit is 40 mol%, and the preferred upper limit is 85 mol%, and more preferable lower limit is 60 mol%, and more preferable upper limit is 75 mol%.

The lower limit of the hydroxy group content in the polyvinyl acetal resin is preferably 15 mol%, and its upper limit is preferably 35 mol%. When the hydroxy group content is 15 mol% or more, the adhesion to the first transparent sheet and the second transparent sheet, particularly the adhesion in the case where the first transparent sheet and the second transparent sheet are made of inorganic glass, is likely to be improved, and the penetration resistance and the like of the laminated structure is likely to be improved. When the hydroxy group content is 35 mol% or less, the transparent sheet member is prevented from being too hard. The lower limit of the hydroxy group content is more preferably 25 mol%, and the upper limit is more preferably 33 mol%.

Also in the case where poly(vinyl butyral) resin is used as the polyvinyl acetal resin, the lower limit of the hydroxy group content is preferably 15 mol%, more preferably 25 mol%, and its upper limit is preferably 35 mol%, more preferably 33 mol%, from similar viewpoints.

The degree of acetalization and the hydroxy group content can be measured by, for example, a method according to JIS K 6728 "Testing methods for poly(vinyl butyral)".

The polyvinyl acetal resin can be prepared by acetalizing poly(vinyl alcohol) with an aldehyde. Poly(vinyl alcohol) is usually obtained by saponifying poly(vinyl acetate), and poly(vinyl alcohol) with a degree of saponification of 80 to 99.8 mol% is commonly used.

The lower limit of the degree of polymerization of the polyvinyl acetal resin is preferably 500, and its upper limit is preferably 4000. When the degree of polymerization is 500 or more, good penetration resistance of the laminated structure is achieved. When the degree of polymerization is 4000 or less, formation of the laminated structure is facilitated. The lower limit of the degree of polymerization is more preferably 1000, and the upper limit is more preferably 3600.

The above aldehyde is not particularly limited, but commonly, an aldehyde having 1 to 10 carbon atoms is suitably used. The aldehyde having 1 to 10 carbon atoms is not particularly limited, and its examples include n-butyraldehyde, isobutyraldehyde, n-valeraldehyde, 2-ethylbutyraldehyde, n-hexylaldehyde, n-octylaldehyde, n-nonylaldehyde, n-decylaldehyde, formaldehyde, acetaldehyde, and benzaldehyde. Among them, n-butyraldehyde, n-hexylaldehyde, and n-valeraldehyde are preferable, and n-butyraldehyde is more preferable. These aldehydes may be used singly, or in combinations of two or more.

### (Ethylene-Vinyl Acetate Copolymer Resin)

The ethylene-vinyl acetate copolymer resin used for the transparent sheet member may be a non-crosslinkable ethylene-vinyl acetate copolymer resin or a high-temperature-crosslinkable ethylene-vinyl acetate copolymer resin. A modified ethylene-vinyl acetate resin such as a saponified product of ethylene-vinyl acetate copolymer and a hydrolysate of ethylene-vinyl acetate may also be used as the ethylene-vinyl acetate copolymer resin.

The vinyl acetate content in the ethylene-vinyl acetate copolymer resin measured according to JIS K 6730 "Testing methods for ethylene/vinyl acetate copolymer materials" is preferably 10 to 50 mass%, more preferably 20 to 40 mass%. When the vinyl acetate content is equal to or higher than the lower limit, the adhesion between the transparent sheet member and the first and second transparent sheets and the penetration resistance of the laminated structure are likely to be improved. When the vinyl acetate content is equal to or lower than the upper limit, the breaking strength of the transparent sheet member is enhanced, and the impact resistance of the laminated structure is improved.

### (Ionomer Resin)

The ionomer resin used for the transparent sheet member is not particularly limited, and various ionomer resins can be used. Specific examples include ethylene ionomers, styrene ionomers, perfluorocarbon ionomers, telechelic ionomers, and polyurethane ionomers. Among these ionomers, ethylene ionomers are preferable because the mechanical strength, durability, transparency, and the like of the laminated structure are improved and because the adhesion to the first transparent sheet and the second transparent sheet in the case where the first transparent sheet and the second transparent sheet are made of glass is improved.

As the ethylene ionomer, an ionomer constituted of an ethylene/unsaturated carboxylic acid copolymer is suitably used, because this ionomer shows good transparency and toughness. The ethylene/unsaturated carboxylic acid copolymer is a copolymer having at least a constitutional unit derived from ethylene, a constitutional unit derived from an unsaturated carboxylic acid, and optionally a constitutional unit derived from another monomer.

Examples of the unsaturated carboxylic acid include acrylic acid, methacrylic acid, and maleic acid. Acrylic acid and methacrylic acid are preferable, and methacrylic acid is particularly preferable. Examples of the other monomer include acrylic esters, methacrylic esters, and 1-butene.

The ethylene/unsaturated carboxylic acid copolymer preferably contains 75 to 99 mol% of the constitutional unit derived from ethylene and 1 to 25 mol% of the constitutional unit derived from the unsaturated carboxylic acid, with the total of the constitutional units of the copolymer being 100 mol%.

The ionomer constituted of the ethylene/unsaturated carboxylic acid copolymer is an ionomer resin obtained by neutralizing or crosslinking at least part of carboxy groups contained in the ethylene/unsaturated carboxylic acid copolymer using metal ions, and the degree of neutralization of the carboxy groups is typically 1 to 90%, preferably 5 to 85%.

Examples of the ion source of the ionomer resin include alkali metals such as lithium, sodium, potassium, rubidium, and cesium and polyvalent metals such as magnesium, calcium, and zinc. Sodium and zinc are preferable.

The ionomer resin can be produced by a conventionally known method without particular limitation. For example, in the case where the ionomer constituted of the ethylene/unsaturated carboxylic acid copolymer is used as the ionomer resin, ethylene and the unsaturated carboxylic acid are free-radically copolymerized under high temperature and pressure to produce the ethylene/unsaturated carboxylic acid copolymer. The ethylene/unsaturated carboxylic acid copolymer reacts with a metal compound containing the above ion source, so that the ionomer constituted of the ethylene/unsaturated carboxylic acid copolymer can be produced.

### (Polyurethane Resin)

Examples of the polyurethane resin include polyurethanes obtained from the reaction of an isocyanate compound and a diol compound, and polyurethanes obtained from the reaction of an isocyanate compound, a diol compound, and a chain-lengthening agent such as polyamines. The polyurethane resin may contain sulfur atoms. In such a case, it is preferable that part of or the whole of the above diol be selected from among polythiols and sulfur-containing polyols. The polyurethane resin can improve the adhesion to organic glass. Hence, the polyurethane resin is suitably used in the case where at least one of the first transparent sheet and the second transparent sheet is made of organic glass.

### (Thermoplastic Elastomer)

Examples of the thermoplastic elastomer include styrene-based thermoplastic elastomers and aliphatic polyolefins.

A known elastomer can be used as the styrene-based thermoplastic elastomer without particular limitation. The styrene-based thermoplastic elastomer in general contains a styrene monomer polymer block serving as a hard segment and a conjugated diene compound polymer block or its hydrogenated block serving as a soft segment. Specific examples of the styrene-based thermoplastic elastomer include styrene-isoprene diblock copolymers, styrene-butadiene diblock copolymers, styrene-isoprene-styrene triblock copolymers, styrene-butadiene/isoprene-styrene triblock copolymers, styrene-butadiene-styrene triblock copolymers, and their hydrogenated products.

The aliphatic polyolefin may be a saturated aliphatic polyolefin or an unsaturated aliphatic polyolefin. The aliphatic polyolefin may be a polyolefin constituted of a chain olefin as the monomer or a polyolefin constituted of a cyclic olefin as the monomer. To effectively enhance the storage stability and sound-insulating property of an interlayer, the aliphatic polyolefin is preferably a saturated aliphatic polyolefin.

Examples of the material of the aliphatic polyolefin include ethylene, propylene, 1-butene, trans-2-butene, cis-2-butene, 1-pentene, trans-2-pentene, cis-2-pentene, 1-hexene, trans-2-hexene, cis-2-hexene, trans-3-hexene, cis-3-hexene, 1-heptene, trans-2-heptene, cis-2-heptene, trans-3-heptene, cis-3-heptene, 1-octene, trans-2-octene, cis-2-octene, trans-3-octene, cis-3-octene, trans-4-octene, cis-4-octene, 1-nonene, trans-2-nonene, cis-2-nonene, trans-3-nonene, cis-3-nonene, trans-4-nonene, cis-4-nonene, 1-decene, trans-2-decene, cis-2-decene, trans-3-decene, cis-3-decene, trans-4-decene, cis-4-decene, trans-5-decene, cis-5-decene, 4-methyl-1-pentene, and vinylcyclohexane.

### (Plasticizer)

In the case where the transparent sheet member contains a thermoplastic resin, a plasticizer may be further contained. The transparent sheet member is made more flexible by the plasticizer contained therein, thereby the laminated structure is also made flexible. In addition, high adhesion to a glass plate can be provided. Use of the plasticizer in the case where a polyvinyl acetal resin is used as the thermoplastic resin is particularly effective.

Examples of the plasticizer include triethylene glycol di-2-ethylbutyrate, triethylene glycol di-2-ethylhexanoate, triethylene glycol dicaprylate, triethylene glycol di-n-octanoate, triethylene glycol di-n-heptanoate, tetraethylene glycol din-heptanoate, tetraethylene glycol di-2-ethylhexanoate, dibutyl sebacate, dioctyl azelate, dibutyl carbitol adipate, ethylene glycol di-2-ethylbutyrate, 1,3-propylene glycol di-2-ethylbutyrate, 1,4-butylene glycol di-2-ethylbutyrate, 1,2-butylene glycol di-2-ethylbutyrate, diethylene glycol di-2-ethylbutyrate, diethylene glycol di-2-ethylhexanoate, dipropylene glycol di-2-ethylbutyrate, triethylene glycol di-2-ethylpentanoate, tetraethylene glycol di-2-ethylbutyrate, diethylene glycol dicaprylate, triethylene glycol di-n-heptanoate, tetraethylene glycol di-n-heptanoate, triethylene glycol di-2-ethylbutyrate, adipic acid dihexyl, adipic acid dioctyl, adipic acid hexyl cyclohexyl, adipic acid diisononyl, adipic acid heptyl nonyl, sebacic acid dibutyl, oil-modified sebacic acid alkyds, mixtures of phosphoric acid esters and adipic acid esters, adipic acid esters, mixed adipic acid esters prepared from alkyl alcohols each having 4 to 9 carbon atoms and cyclic alcohols each having 4 to 9 carbon atoms, and adipic acid esters each having 6 to 8 carbon atoms, such as adipic acid hexyl. Among the above plasticizers, triethylene glycol di-2-ethylhexanoate (3GO) is particularly suitably used.

The content of the plasticizer is not particularly limited, and its lower limit is preferably 30 parts by mass, and its upper limit is preferably 70 parts by mass, relative to 100 parts by mass of the thermoplastic resin. When the content of the plasticizer is 30 parts by mass or more, the transparent sheet member becomes reasonably flexible, and its handleability is improved. When the content of the plasticizer is 70 parts by mass or less, separation of the plasticizer from the transparent sheet member is prevented. The lower limit of the content of the plasticizer is more preferably 35 parts by mass, and the upper limit is more preferably 63 parts by mass.

In the case where the thermoplastic resin is comprised in the transparent sheet member of the present invention, the thermoplastic resin or the combination of the thermoplastic resin and the plasticizer serves as the main component of the transparent sheet member. The total amount of the thermoplastic resin and the plasticizer is typically 70 mass% or more, preferably 80 mass% or more, further preferably 90 mass% or more, based on the total amount of the transparent sheet member.

### (Other Additives)

The transparent sheet member may contain an additive such as an antioxidant, an adhesion control agent, a pigment, and a dye as needed.

The antioxidant is not particularly limited, and examples of the antioxidant include 2,2-bis[[[3-(3,5-di-tert-butyl-4-hydroxyphenyl)propionyl]oxy]methyl]propane-1,3-diol 1,3-bis[3-(3,5-di-tert-butyl-4-hydroxyphenyl)propionate], 4,4'-thiobis(6-tert-butyl-3-methylphenol), 4,4'-dimethyl-6,6'-di(tert-butyl)[2,2'-methylenebis(phenol)], 2,6-di-t-butyl-p-cresol, and 4,4'-butylidenebis-(6-t-butyl-3-methylphenol).

### (First Transparent Sheet and Second Transparent Sheet)

The first transparent sheet and the second transparent sheet may be made of a material which can be used for a window. As a specific example, they may be made of inorganic glass or organic glass. The inorganic glass is not particularly limited, and examples of the inorganic glass include clear glass, float plate glass, polished plate glass, figured glass, net-wired sheet glass, line-wired plate glass, and green glass.

The organic glass is not particularly limited, and examples of the organic glass include a transparent resin plate made of a polycarbonate, an acrylic resin, an acrylic copolymer resin, or a polyester.

In the case where both of the first transparent sheet and the second transparent sheet are used, the sheets may be made of the same material or different materials. For example, the first transparent sheet may be made of inorganic glass, and the second transparent sheet may be made of organic glass. It is preferable that the first transparent sheet and the second transparent sheet be both made of inorganic glass or both made of organic glass.

The visible light transmittance of the first transparent sheet is preferably as high as possible, but is practically 50% or more, preferably 60% or more. The visible light transmittance of the first transparent sheet is 100% or less, practically 99% or less.

In the case where the second transparent sheet is used, its visible light transmittance may fall within the range described for the first transparent sheet. The first transparent sheet and the second transparent sheet may have identical visible light transmittance with each other or different visible light transmittances.

The thickness of the first transparent sheet is preferably 0.1 to 10 mm, more preferably 0.3 to 7 mm. In the case where the second transparent sheet is used, its thickness may fall within the range of the thickness of the first transparent sheet. The thicknesses of the first transparent sheet and the second transparent sheet may be identical with each other or different from each other.

The method for production of the laminated structure is not particularly limited, and various known methods, such as a method of laminating and pressure-bonding the first transparent sheet and the transparent sheet member and a method of disposing an adhesive layer between the first transparent sheet and the transparent sheet member to laminate them may be employed. In the case where the second transparent sheet is used, the production may be performed by, for example, disposing at least the transparent sheet member between the first transparent sheet and the second transparent sheet and integrating the sheets by pressure-bonding or the like.

### <Solar Cell System>

The solar cell system of the present invention includes the laminated structure and the power generation cell. The power generation cell may be disposed such that the power generation cell can receive light guided to the side surface of the laminated structure by reflection or the like within the laminated structure.

Fig. 2 shows a solar cell system 22 including the laminated structure 20 and a power generation cell 21 as an embodiment. The power generation cell 21 is disposed outside of a side surface 20A of the laminated structure 20. In such a case, the power generation cell 21 may be disposed to be in contact with the side surface 20A of the laminated structure 20, as shown in Fig. 2 or may be spaced apart from the side surface 20A of the laminated structure 20 to face the side surface 20A. The power generation cell 21 is not required to be disposed outside of the side surface, but may be disposed in a peripheral area of the laminated structure 20. For example, the power generation cell 21 may be embedded in the laminated structure 20.

The power generation cell 21 may be disposed such that the power generation cell 21 can receive light propagating through the laminated structure 20 over the entire laminated structure 20 in the thickness direction as shown in Fig. 2, or may be disposed such that it can receive light propagating through the inside of the sheet-shaped structure 20 over part thereof in the thickness direction.

### [Power Generation Cell]

The power generation cell used in the solar cell system is not particularly limited as long as the cell converts light into electricity. A cell that efficiently converts light with the maximum emission wavelength or wavelengths around the maximum into electricity is preferably used as the power generation cell. The power generation cell has the maximum power generation efficiency preferably at a wavelength in the range of 780 nm or more, more preferably at a wavelength within 800 to 1400 nm, further preferably at a wavelength within 820 to 1300 nm. When the power generation efficiency from light in the near infrared region is high as described above, the power generation efficiency can be enhanced in the case when the maximum emission wavelength is in the near infrared region.

Specific examples of the power generation cell include a power generation cell in which a silicon-based semiconductor such as monocrystalline silicon, polycrystalline silicon, and amorphous silicon is used as a photoelectric conversion layer thereof, a power generation cell in which a compound semiconductor typified by CuInSe-based, Cu(In,Ga)Se-based, Ag(In,Ga)Se-based, CuInS-based, Cu(In,Ga)S-based, and Ag(In,Ga)S-based compounds, solid solutions thereof, and CIS-based, CIGS-based, GaAs-based, and CdTe-based is used as a photoelectric conversion layer thereof, and an organic power generation cell in which an organic material such as an organic dye is used for a photoelectric conversion layer thereof.

To enhance the power generation efficiency from light in the near infrared region, a power generation cell in which a silicon semiconductor or a compound semiconductor (CIS or CIGS) is used for a photoelectric conversion layer thereof is preferable.

The solar cell system of the present invention is used such that one surface of the laminated structure constituting the solar cell system is disposed on the exterior side, from which sunlight is incident, as described above. The solar cell system of the present invention can be used in various fields, preferably for exterior windows of various conveyances such as automobiles, trains, and ships, and various constructions such as buildings, apartments, stand-alone houses, halls, and gymnasiums. In the present specification, the exterior window means a window located at a position on which sunlight is made incident. Hence, the exterior window is typically disposed on the outer surface of a building or a conveyance, but the exterior window of the present specification also includes an inner pane of a double-glazed window as long as the pane is located at a position on which sunlight is made incident.

Further, in an automobile, the solar cell system may be used for a rear window, a side window, or a roof window.

### Examples

The present invention will be described in more detail by referring to examples, but the present invention is by no means limited by these Examples.

Methods for measuring and evaluating the physical properties employed in the present invention are as follows.

### [Maximum Excitation Wavelength and Maximum Emission Wavelength]

The maximum excitation wavelength is a wavelength of excitation light at which the fluorescence intensity that is detected under a condition of the maximum emission wavelength reaches a maximum, when excitation light with wavelengths of 300 to 500 nm is radiated from Fluorolog-3 manufactured by HORIBA, Ltd. The maximum emission wavelength is a wavelength at which the emission intensity that is detected under a condition of 780 to 1400 nm reaches a maximum, when light with the maximum excitation wavelength is radiated.

### [Transmittance]

The visible light transmittance of the laminated structure in the range of 380 to 780 nm was measured according to JIS R 3212 with a UV/Vis/IR spectrophotometer (manufactured by Hitachi High-Technologies Corporation, UH4150).

### [Refractive Index]

The refractive index of each of the transparent sheets and the transparent sheet member was measured with a digital Abbe refractometer (manufactured by Atago Co., Ltd., DR-A1).

### [Amount of Light at End]

Simulated sunlight was incident on one surface of the laminated structure, that is, the first transparent sheet side, and the amount of light outgoing from the side surface of the laminated structure was measured. The amount (%) of light at an end was obtained from the expression 100 × the amount of light/incident energy. Solar simulator HAL-C100 manufactured by Asahi Spectra Co., Ltd. was used as the source of the simulated sunlight, and the amount of light was measured with a light amount measurement device manufactured by Asahi Spectra Co., Ltd.

The amount (%) of light at an end was evaluated on the following criteria.
A: Equal to or more than 1.5%
B: Less than 1.5%

Compounds and materials used for the transparent sheets of respective examples and comparative examples are as follows.
<Poly(vinyl butyral) Resin> The degree of acetalization: 1 mol%, the hydroxy group content: 30.5 mol%, the degree of polymerization: 1700
<Ethylene-Vinyl Acetate Copolymer Resin (EVA)> The vinyl acetate content: 30 mass%
<Plasticizer> Triethylene glycol di-2-ethylhexanoate (3GO)
<Antioxidant> 2,6-Di-t-butyl-p-cresol (BHT)
<Wavelength Conversion Material> BaSnO₃

The average particle diameter: 50 nm, the maximum excitation wavelength: 370 nm, the maximum emission wavelength: 840 nm

### <Wavelength Conversion Material> Y₂SiO₅:Ce,Yb

The average particle diameter: 50 nm, the maximum excitation wavelength: 360 nm, the maximum emission wavelength: 1020 nm

### <Wavelength Conversion Material> Y₂SiO₅:Pr,Yb

The average particle diameter: 50 nm, the maximum excitation wavelength: 400 nm, the maximum emission wavelength: 1020 nm

### <Wavelength Conversion Material> Diethyl 2,5-dihydroxyterephthalate manufactured by Sigma-Aldrich Co. LLC

The average particle diameter: 50 nm, the maximum excitation wavelength: 390 nm, the emission wavelength: 420 nm

### [Example 1]

### (1) Production of Transparent Sheet Member

To 100 parts by mass of poly(vinyl butyral) resin, 40 parts by mass of the plasticizer, 0.2 parts by mass of the antioxidant, and 0.05 parts by mass of BaSnO₃ as a wavelength conversion material were added and mixed. The mixture was extrusion-molded with a twin-screw anisotropic extruder to produce a transparent sheet member with a thickness of 760 µm.

### (2) Production of Laminated Structure

The resulting transparent sheet member was cut into a sheet shape with the size of 300 mm in length × 300 mm in width. The transparent sheet member was inserted between two transparent clear glass plates (5 mm in thickness × 300 mm × 300 mm) used as the first transparent sheet and the second transparent sheet, and the product was temporarily bonded together by pressing. The temporarily bonded product was subjected to pressure bonding under conditions of a pressure of 1.2 MPa at 150°C in an autoclave for 30 minutes to provide a laminated structure.

Table 1 shows the evaluation results for the resulting laminated structure.

### [Examples 2 to 8]

Laminated structures of Examples 2 to 8 were obtained in substantially the same manner as in Example 1, by using materials shown in Tables 1 and 2 for the resins for the transparent sheet members, the wavelength conversion materials, the first transparent sheets, and the second transparent sheets.

### [Comparative Example 1]

### (1) Production of Another Transparent Sheet

To 100 parts by mass of poly(vinyl butyral) resin, 40 parts by mass of the plasticizer and 0.2 parts by mass of the antioxidant were added and mixed. The mixture was extrusion-molded with a twin-screw anisotropic extruder to produce another transparent sheet with a thickness of 760 µm.

### (2) Production of Laminated Structure

The resulting other transparent sheet was cut into a sheet shape with the size of 300 mm in length × 300 mm in width. The other transparent sheet was inserted between two transparent clear glass plates (5 mm in thickness × 300 mm × 300 mm) used as the first transparent sheet and the second transparent sheet, and the product was temporarily bonded together by pressing. The temporarily bonded product was subjected to pressure bonding under conditions of a pressure of 1.2 MPa at 150°C in an autoclave for 30 minutes to provide a laminated structure.

Table 3 shows the evaluation results for the resulting laminated structure.

### [Comparative Example 2]

### (1) Production of Transparent Sheet Member

A transparent sheet member was obtained in substantially the same manner as in Example 1, except that diethyl 2,5-dihydroxyterephthalate was used as a wavelength conversion material.

### (2) Production of Laminated Structure

A laminated structure was obtained in substantially the same manner as in Example 1.

### [Comparative Example 3]

### (1) Production of Transparent Sheet Member

To 100 parts by mass of poly(ethylene terephthalate) resin, 0.05 parts by mass of BaSnO₃ as a wavelength conversion material was added and mixed. The mixture was extrusion-molded with a twin-screw anisotropic extruder to produce a transparent sheet member with a thickness of 760 µm.

### (2) Production of Another Transparent Sheet

Another transparent sheet was obtained in substantially the same manner as in Comparative Example 1. Table 3 shows the evaluation results for the resulting laminated structure.

### (3) Production of Laminated Structure

The resulting transparent sheet member and the other transparent sheet were cut into a sheet shape with the size of 300 mm in length × 300 mm in width. The other transparent sheet was inserted between a transparent clear glass plate (5 mm in thickness × 300 mm × 300 mm) used as the first transparent sheet and the transparent sheet member, and the product was temporarily bonded together by pressing. The temporarily bonded product was subjected to pressure bonding under conditions of a pressure of 1.2 MPa at 150°C in an autoclave for 30 minutes to provide a laminated structure.

Table 3 shows the evaluation results for the resulting laminated structure.

**Table 1**

| | | | | Example 1 | Example 2 | Example 3 | Example 4 |
|---|---|---|---|---|---|---|---|
| Laminate d structure | First transparent sheet | Member | Name | Clear glass | Clear glass | Clear glass | Optical glass |
| | | Refractive index | nₐ₁ | 1.52 | 1.50 | 1.49 | 1.85 |
| | Transparen t sheet member | Member | Name | Poly(vinyl butyral) | Poly(vinyl butyral) | Poly(vinyl butyral) | Poly(vinyl butyral) |
| | | Refractive index | n_{b} | 1.47 | 1.48 | 1.48 | 1.47 |
| | | Wavelength conversion material | Compound | BaSnO₃ | BaSnO₃ | BaSnO₃ | BaSnO₃ |
| | | | Parts by mass^{*1} | 0.05 | 0.05 | 0.05 | 0.05 |
| | | Maximum excitation wavelength | nm | 370 | 370 | 370 | 370 |
| | | Maximum emission wavelength | nm | 840 | 840 | 840 | 840 |
| | Second transparent sheet | Member | Name | Clear glass | Clear glass | Clear glass | Optical glass |
| | | Refractive index | nₐ₂ | 1.52 | 1.50 | 1.49 | 1.85 |
| | Another transparent sheet | Member | Name | - | - | - | - |
| | | Refractive index | nc | | | | |
| | Layered structure of laminated structure | | | First transparent sheet/T ransparen t sheet member/Second transparent sheet | First transparent sheet/T ransparen t sheet member/Second transparent sheet | First transparent sheet/T ransparen t sheet member/Second transparent sheet | First transparent sheet/T ransparen t sheet member/Second transparent sheet |
| Evaluatio n | Visible light transmittance | | % | 80 | 80 | 80 | 78 |
| | Difference in refractive index na1-nb | | Difference | 0.05 | 0.02 | 0.01 | 0.38 |
| | | | Evaluation | A | A | A | A |
| | Amount of light at end | | % | 2.5 | 2.3 | 1.9 | 2.2 |
| | | | Evaluation | A | A | A | A |

| | | | | | | | |
|---|---|---|---|---|---|---|---|
| *1 Parts by mass relative to 100 parts by mass of the material constituting the member (poly(vinyl butyral)) | | | | | | | |

**Table 2**

| | | | | Example 5 | Example 6 | Example 7 | Example 8 |
|---|---|---|---|---|---|---|---|
| Laminate d structure | First transparent sheet | Member | Name | Clear glass | Clear glass | Clear glass | Polycarbonate |
| | | Refractive index | nₐ₁ | 1.52 | 1.52 | 1.52 | 1.59 |
| | Transparen t sheet member | Member | Name | Poly(vinyl butyral) | Poly(vinyl butyral) | EVA | Poly(vinyl butyral) |
| | | Refractive index | n_{b} | 1.47 | 1.47 | 1.49 | 1.47 |
| | | Wavelength conversion material | Compound | Y₂SiO₅:Ce,Yb | Y₂SiO₅:Pr,Yb | BaSnO₃ | BaSnO₃ |
| | | | Parts by mass^{*1} | 0.05 | 0.05 | 0.05 | 0.05 |
| | | Maximum excitation wavelength | nm | 360 | 400 | 370 | 370 |
| | | Maximum emission wavelength | nm | 1020 | 1020 | 840 | 840 |
| | Second transparent sheet | Member | Name | Clear glass | Clear glass | Clear glass | Polycarbonate |
| | | Refractive index | na2 | 1.52 | 1.52 | 1.52 | 1.59 |
| | Another transparent sheet | Member | Name | - | - | - | - |
| | | Refractive index | n_{c} | | | | |
| | Layered structure of laminated structure | | | First transparent sheet/T ransparen t sheet member/Second transparent sheet | First transparent sheet/T ransparen t sheet member/Second transparent sheet | First transparent sheet/T ransparen t sheet member/Second transparent sheet | First transparent sheet/T ransparen t sheet member/Second transparent sheet |
| Evaluatio n | Visible light transmittance | | % | 80 | 80 | 75 | 70 |
| | Difference in refractive index na1-nb | | Difference | 0.05 | 0.05 | 0.03 | 0.12 |
| | | | Evaluation | A | A | A | A |
| | Amount of light at end | | % | 3.5 | 3.4 | 2.1 | 2.3 |
| | | | Evaluation | A | A | A | A |

| | | | | | | | |
|---|---|---|---|---|---|---|---|
| *1 Parts by mass relative to 100 parts by mass of the material constituting the member (poly(vinyl butyral) or EVA) | | | | | | | |

**Table 3**

| | | | | Comparative Example 1 | Comparative Example 2 | Comparative Example 3 |
|---|---|---|---|---|---|---|
| Laminated structure | First transparent sheet | Member | Name | Clear glass | Clear glass | Clear glass |
| | | Refractive index | nₐ₁ | 1.52 | 1.52 | 1.52 |
| | Transparent sheet member | Member | Name | - | Poly(vinyl butyral) | Poly(ethylene terephthalate) |
| | | Refractive index | n_{b} | | 1.47 | 1.6 |
| | | Wavelength conversion material | Compound | | Terephthalic acid ester*² | BaSnO₃ |
| | | | Parts by mass^{*1} | | 0.05 | 0.05 |
| | | Maximum excitation wavelennth | nm | | 390 | 370 |
| | | Maximum emission wavelength | nm | | 420 | 840 |
| | Second transparent sheet | Member | Name | Clear glass | Clear glass | |
| | | Refractive index | na2 | 1.52 | 1.52 | |
| | Another transparent sheet | Member | Name | Poly(vinyl butyral) | - | Poly(vinyl butyral) |
| | | Refractive index | n_{c} | 1.47 | | 1.47 |
| | Layered structure of laminated structure | | | First transparent sheet/Another transparent sheet/Second transparent sheet | First transparent sheet/Transparent sheet member/Second transparent sheet | First transparent sheet/Another transparent sheet/Transparent sheet member |
| Evaluation | Visible light transmittance | | % | 85 | 80 | 80 |
| | Difference in refractive index na1-nb | | Difference | - | 0.05 | -0.08 |
| | | | Evaluation | - | A | B |
| | Amount of light at end | | % | 0.5 | 1 | 1.3 |
| | | | Evaluation | B | B | B |

| | | | | | | |
|---|---|---|---|---|---|---|
| *1 Parts by mass relative to 100 parts by mass of the material constituting the member (poly(vinyl butyral) or poly(ethylene terephthalate)) *2 Diethyl 2,5-dihydroxyterephthalate | | | | | | |

Examples 1 to 8 showed that a laminated structure in which the first transparent sheet had a higher refractive index than the transparent sheet member containing the wavelength conversion material provided a larger amount (amount of light at an end) of light on the side surface of the laminated structure.

On the other hand, the amount of light on the side surface of the laminated structure was small in the case where the wavelength conversion material was not contained (Comparative Example 1), in the case where the maximum emission wavelength of the wavelength conversion material was less than 780 nm (Comparative Example 2), and in the case where the first transparent sheet had a lower refractive index than the transparent sheet member containing the wavelength conversion material (Comparative Example 3).

### Reference Signs List

- 10: Transparent sheet member
- 11: First transparent sheet
- 12: Second transparent sheet
- 20: Laminated structure
- 20A: Side surface
- 21: Power generation cell
- 22: Solar cell system

## Claims

1. A solar cell system for generating electricity by absorbing sunlight, comprising:
a laminated structure; and
a power generation cell disposed in a peripheral area of the laminated structure,
wherein,
in the laminated structure, a transparent sheet member comprising a wavelength conversion material and a first transparent sheet are laminated,
a maximum emission wavelength of the wavelength conversion material is 780 nm or more, and
a refractive index nₐ₁ of the first transparent sheet is higher than a refractive index n_{b} of the transparent sheet member.

2. The solar cell system according to claim 1, wherein the refractive index n_{b} of the transparent sheet member is 1.30 to 1.80.

3. The solar cell system according to claim 1 or 2, wherein the first transparent sheet is disposed on an exterior side of the transparent sheet member.

4. The solar cell system according to any of claims 1 to 3, wherein the laminated structure comprises the transparent sheet member and first and second transparent sheets disposed on both surfaces, respectively, of the transparent sheet member.

5. The solar cell system according to claim 4, wherein a refractive index nₐ₂ of the second transparent sheet is higher than the refractive index n_{b} of the transparent sheet member.

6. The solar cell system according to any of claims 1 to 5,
wherein the transparent sheet member comprises a resin, and
the wavelength conversion material is dispersed in the resin.

7. The solar cell system according to any of claims 1 to 6, wherein the first transparent sheet is either inorganic glass or organic glass.
